# EUROPEAN PATENT SPECIFICATION

(11) **EP 0 774 806 B1**
(45) Date of publication and mention of the grant of the patent: **31.05.2000**
(21) Application number: 96118233.4
(22) Date of filing: 14.11.1996
(51) Int. Cl.: H01R 12/18, H01R 13/648, H01R 12/16

(54) **Biased edge card shielded connector**
Abgeschirmter, vorgespannter Leiterplatten-Eckverbinder
Connecteur de bord blindé pour des plaquettes chargé initialement

(30) Priority: 20.11.1995 JP 32508695
(43) Date of publication of application: 21.05.1997
(73) Proprietor: MOLEX INCORPORATED, Lisle Illinois 60532 (US); Nintendo Kabushikikaisya, Kyoto-shi, Kyoto (JP)
(72) Inventor: Takamoto, Junji, Nintendo Co. H. Apt.-11, Minami-ku, Kyoto-shi, Kyoto-fu (JP); Koshiishi, Kazunori, Hiradata-shi, Asaka-fu (JP); Tojo, Katsutoshi, Machida-shi, Tokyo (JP)
(74) Representative: Blumbach, Kramer & Partner GbR

(56) References cited:
- EP-A- 0 458 483
- EP-A- 0 459 356
- US-A- 5 203 725
- US-A- 5 288 247
- US-A- 5 378 159

## Description

### SPECIFICATION

### Field of the Invention

This invention generally relates to the art of electrical connectors and, particularly, to a biased edge card connector having a conductive shield which provides a biasing means.

### Background of the Invention

In today's high speed electronic equipment, it is desirable that all components in an interconnection path be optimized for signal transmission characteristics, otherwise the performance of the system will be impaired or degraded. Such characteristics include risetime degradation or system bandwidth, crosstalk, impedance control and propagation delay. Ideally, the characteristics of an electrical connector would have little or no affect on the interconnection system. An ideal connector would be "transparent". In other words, the system would function as if the connector did not exist as part of the interconnection. However, such an ideal connector is generally impractical or impossible, and continuous efforts are made to develop electrical connectors which have as little affect on the system as possible.

It has been found that inductance is one of the major concerns in designing an ideal connector. This is particularly true in electrical connectors for high speed electronic equipment, i.e. involving the transmission of high frequencies. A very popular type of electrical connector for such applications commonly is termed an "edge card" connector. In other words, an edge connector is provided for receiving a printed circuit board having a mating edge and a plurality of contact pads adjacent the edge. Such edge connectors have an elongated housing defining an elongated slot for receiving the mating edge of the printed circuit board. A plurality of terminals are spaced along one or both sides of the slot for engaging the contact pads adjacent the mating edge of the board. Most often, the terminals have some form or another of spring contact elements for biased engagement against the contact pads on the board and, most often, the spring contact elements are in one form or another of a cantilevered spring arm.

With electrical connectors of the character described above, given electrical contacts of otherwise comparable geometry, the longer the spring contact arm or contact beam, the greater the inductance of the terminal and, cumulatively, the electrical connector itself. Therefore, it is desirable to have as short a contact beam as possible. Shortening the contact beam creates various problems. For instance, it is difficult to maintain constant contact pressures in a multiplicity of spring contact beams, particularly when the beams are relatively short. In addition, it is difficult to compensate for variances in the widths of printed circuit boards when the contact beams are short. In fact, such spring contacts can take a permanent set even when the contacts are displaced only a small amount. The contacts might take a permanent set after a relatively wide printed circuit board has been inserted into the connector. This permanent set of the contacts would make the connector ineffective when a relatively narrow board subsequently is inserted into the connector. If the contact beams do not make effective electrical connection with the contact pads on the edge of the printed circuit board, an unreliable or ineffective electrical connection results, rendering the connector effectively useless.

U.S. Patent No. 5,203,725 to Brunker et al, dated April 23, 1993 and assigned to the assignee of the present invention, shows a biased edge card connector directed to solving these problems. That patent discloses an edge card connector of the character described wherein the deflection of the spring contact elements is controlled, resulting in the ability to design very short spring contact beams. Various biasing means are disclosed, including a second, unitary spring portion of one or more of the spring contact elements. In another embodiment, the biasing means may be provided by an integral portion of the connector housing, such as a unitarily molded portion of a plastic housing. In another embodiment, the biasing means may be provided by a spring device mounted on the housing independent of the spring contact elements. Still further, the biasing means may be provided by a cam member, independent of the housing and the spring contact elements, positionable in a board-receiving slot means for camming the printed circuit board against the spring contact elements.

The present invention is directed to providing an edge card connector of the character described wherein the deflection of the spring contact elements is achieved by a shield that surrounds a substantial portion of the connector housing, thereby avoiding any modifications to the connector housing or to the spring contact elements, or the necessity of additional extraneous biasing means or cam members.

Shielded card edge connectors are known from e.g. EP-A-458 483 and EP-A-459 356.

### Summary of the Invention

An object, therefore, of the invention is to provide an edge connector for a printed circuit board having a mating edge and a plurality of contact pads adjacent the edge.

Generally, the edge connector includes a dielectric housing having an elongated mating portion with a board-receiving slot for receiving the edge of the printed circuit board. A plurality of spring contact elements are mounted in the housing along one side only of the slot. The spring contact elements have spring contact portions extending into the slot for contacting respective ones of the contact pads on one side of the printed circuit board.

The housing includes surface means at the one side of the slot defining a datum plane beyond which the spring contact portion of at least one of the spring contact elements extends into the slot. Biasing means is provided in the housing for biasing the printed circuit board against the surface means, thereby deflecting the spring contact portion of at least one spring contact element a predetermined amount.

A shield is mounted on the housing substantially about the mating portion.

The invention herein contemplates that the biasing means comprise a resilient portion of the shield extending into the slot for contacting the printed circuit board on a side of the board opposite the aforesaid one side thereof and biasing the one side of the board against the surface means and the spring contact elements.

In the preferred embodiment, the shield is stamped and formed of sheet metal material. The slot includes an entry mouth into which the mating edge of the printed circuit board is inserted. The resilient portion of the shield comprises an integral cantilevered spring arm which is bent from the exterior of the mating portion of the housing through the mouth and into the slot. The cantilevered spring arm has a width, lengthwise of the slot, substantially greater than the width of the slot.

Other objects, features and advantages of the invention will be apparent from the following detailed description taken in connection with the accompanying drawings.

### Brief Description of the Drawings

The features of this invention which are believed to be novel are set forth with particularity in the appended claims. The invention, together with its objects and the advantages thereof, may be best understood by reference to the following description taken in conjunction with the accompanying drawings, in which like reference numerals identify like elements in the figures and in which:
FIGURE 1 is a vertical section taken generally along line 1-1 of Figure 6;
FIGURE 2 is a vertical section taken generally along line 2-2 of Figure 6;
FIGURE 3 is a vertical section taken generally along line 3-3 of Figure 6;
FIGURE 4 is a front elevational view of an edge connector according to the invention;
FIGURE 5 is a rear elevational view of the connector;
FIGURE 6 is a top plan view of the connector;
FIGURE 7 is a bottom plan view of the connector;
FIGURE 8 is an end elevational view of the connector, looking toward the left-hand of Figures 4-7;
FIGURE 9 is an end elevational view of the connector, looking toward the right-hand end of Figures 4-7;
FIGURE 10 is an exploded perspective view of a cassette for containing a printed circuit board;
FIGURE 11 is a vertical section through the cassette showing how it is positioned over the edge connector, with the edge of the printed circuit board inserted into the connector; and
FIGURE 12 is a plan view of one side of the printed circuit board on which conductive ground pads are formed.

### Detailed Description of the Preferred Embodiment

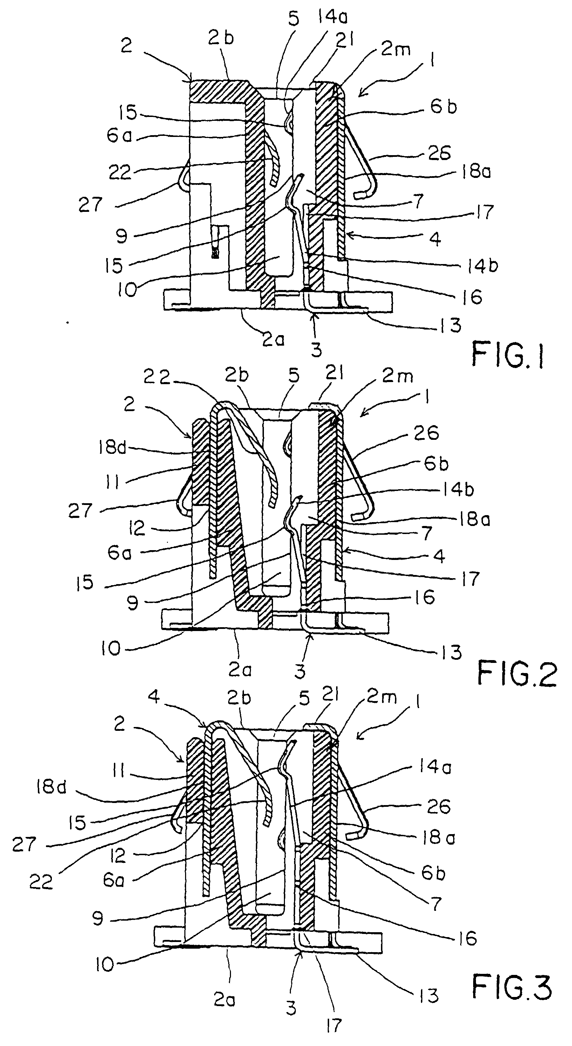

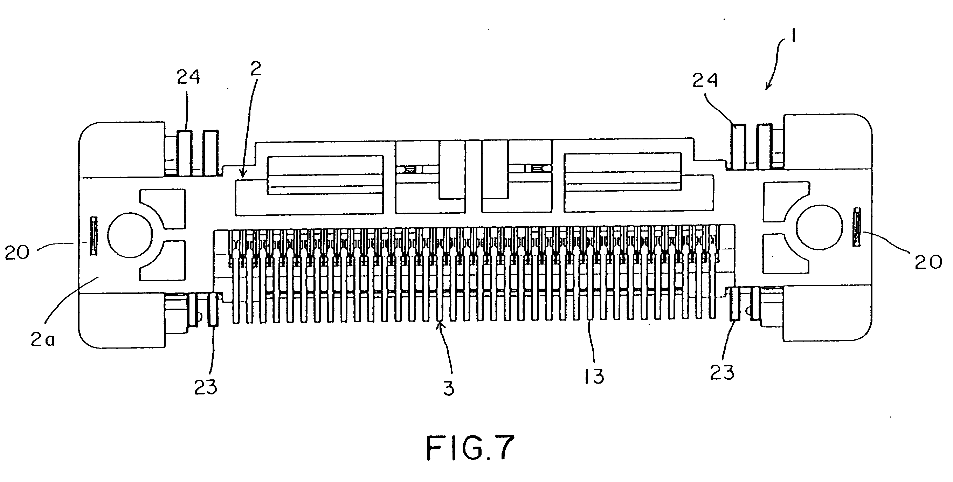

Figures 1-9 show an edge connector, generally designated 1, for receiving a mating edge of a printed circuit board (as described hereinafter). The connector includes an elongated housing 2 of dielectric material, such as of molded plastic. A plurality of terminals, generally designated 3, are inserted into the housing through a bottom board-mounting surface 2a of the housing. A metal shell or shield, generally designated 4, is positioned over a substantial portion of the housing. The shield is stamped and formed of conductive sheet metal material to the desired shape and size.

As best seen in Figures 1, 2 and 3, elongated housing 2 includes a mating portion, generally designated 2m, which has a longitudinal slot 5 defined between a pair of opposite longitudinal side walls 6a and 6b. The longitudinal slot opens at a top surface 2b of the housing for receiving the mating edge of the printed circuit board. One of the opposite walls 6b has a plurality of recesses 7 spaced at regular intervals longitudinally in its inner surface. The inside edges of walls 6b, between recesses 7, define a datum plane 9. The recesses 7 accommodate terminals 3.

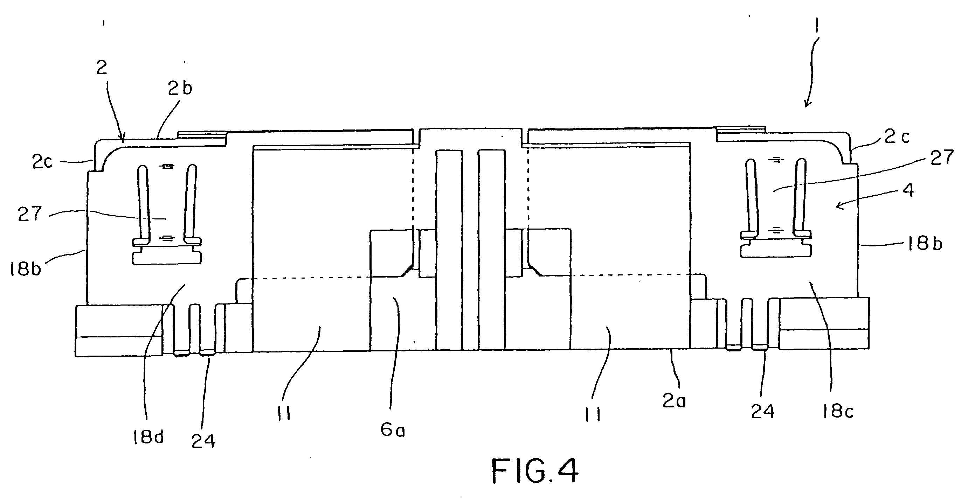

More specifically, each terminal recess 7 extends the full height of housing 2 to open both at top surface 2b and bottom board-mounting surface 2a of the housing, permitting the terminals to be inserted into the recesses from the bottom of the housing. Datum plane 9 will face one major plane or side of the printed circuit board, at the edge of the board, when the board is inserted into slot 5 of the housing. The other opposite wall 6a is chamfered at its top corner, thereby defining a diverging inlet or mouth at the top of longitudinal slot 5. The slot defines a vertical space 10 which communicates with the top or diverging inlet of the slot and functions to guide the mating edge of the printed circuit board downwardly into the slot. As best seen in Figure 4, wall 6a has an outer, integral plate portion 11 which, as seen in Figure 4, is formed by two inverted L-shaped portions integrally connected at their tops or abutting ends, leaving a narrow space between wall 6a and the outer plate portion 11 for inserting the metal shield 4, as seen in Figures 2 and 3.

The plurality of terminals 3 actually are provided by alternating short terminals (Figs. 1 and 2) and long terminals (Fig. 3) lengthwise of the elongated housing and board-receiving slot 5. Each long terminal (Fig. 3) has a long contact stem 14a and a solder tail 13 integrally connected to contact stem 14a. Each short terminal has a short contact stem 14b and a solder tail 13 integrally connected to contact stem 14b. All of the terminals are mounted in the housing with their solder tails 13 generally flush with bottom 2a of the housing, i.e. generally coplanar for soldering to appropriate circuit traces on the printed circuit board. The alternating arrangement of long and short terminals 3 allows for an increasing density of circuit pads at the edge of the printed circuit board. Each contact stem 14a and 14b has a contact portion 15 projecting into slot 5 near the distal end of the contact stem. In other words, with the terminals mounted within recesses 7, contact portions 15 extend into the slot beyond datum plane 9 towards the opposite wall 6a. Contact stems 14a and 14b have pointed projections or teeth 16 at their opposite edges for digging into grooves 17 formed in walls 6b at the sides of recesses 7 to fix the terminals in the housing.

Referring to Figures 4-9 in conjunction with Figures 1-3, metal shield 4 is stamped and formed into an elongated rectangular hollow shape. The shield includes a major section 18a covering substantially the entire area of wall 6b of housing 2. The shield has two minor sections 18b integrally connected to the opposite ends of major section 18a at right angles for covering end walls 2c of the housing. The shield further includes two semi-major sections 18c and 18d integrally connected to minor sections 18b at right angles thereto for covering the opposite end areas of the other wall 6a of the housing. As best seen in Figure 4, semi-major sections 18c and 18d extend toward each other, leaving a rectangular space at the center of housing wall 6a. The shield has fitting nails 23 and 24 projecting from its lower periphery. The shield is mounted on housing 2 from the top of the housing to substantially enclose the housing.

When metal shell or shield 4 is mounted on housing 2, the major section 18a of the shield covers substantially the entire area of the one side wall 6b of the housing. The two minor sections 18b of the shield substantially cover the end walls 2c of the housing. The two semi-major sections 18c and 18d cover a substantial portion of the opposite end areas of the other opposite side wall 6a of the housing. The two semi-major sections 18c and 18d are sandwiched between the outer plate portions 11 of the housing and wall 6a of the housing. As seen in Figures 2 and 3, metal shield 4 has a longitudinal lip 21 extending inwardly from the top edge of major section 18a to abut against the top edge of wall 6b of the housing when the shield is fully mounted on the housing.

The invention contemplates that metal shell or shield 4 include two resilient portions in the form of cantilevered spring arms 22 formed integrally with semi-major sections 18c and 18d of the shell. The spring arms are formed or bent so that they extend downwardly into slot 5 as is clearly seen in Figures 2 and 3. The cantilevered spring arms contact the printed circuit board inserted into slot 5 on a side of the board opposite the side which has contact pads for engaging contact portions 15 of terminals 3. In essence, the resilient portions provided by cantilevered spring arms 22 bias the board against the spring contact portions and datum plane 9.

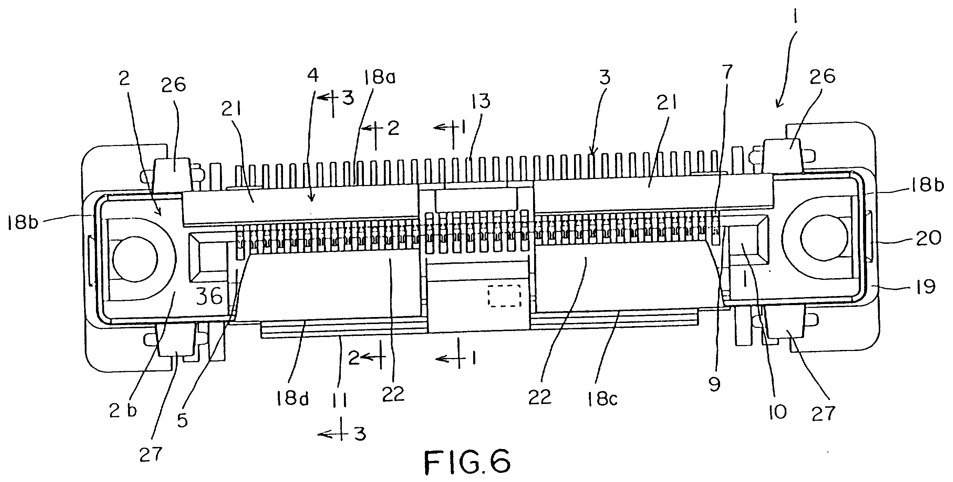

As seen in Figure 6, the width of each cantilevered spring arm 22 of shield 4 is substantially greater than the width of slot 5. More importantly, the combined width of the two cantilevered spring arms is greater than the combined width of contact stems 14a and 14b of terminals 3 so that the cantilevered spring arms bias the printed circuit board against surface means or datum plane 9, overcoming the spring forces of the terminals. In other words, the spring forces of the cantilevered spring arms must be greater than the spring forces of the terminals so that the spring arms are effective to bias the edge card or printed circuit board against datum plane 9.

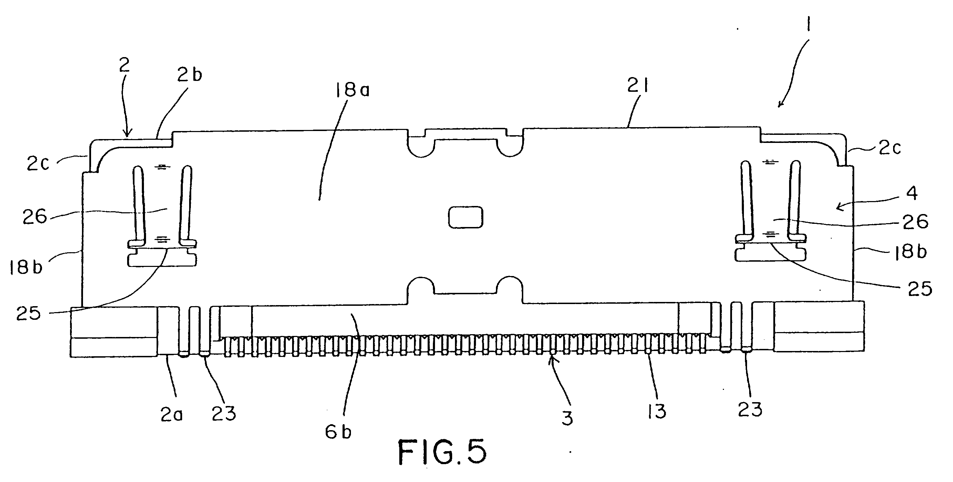

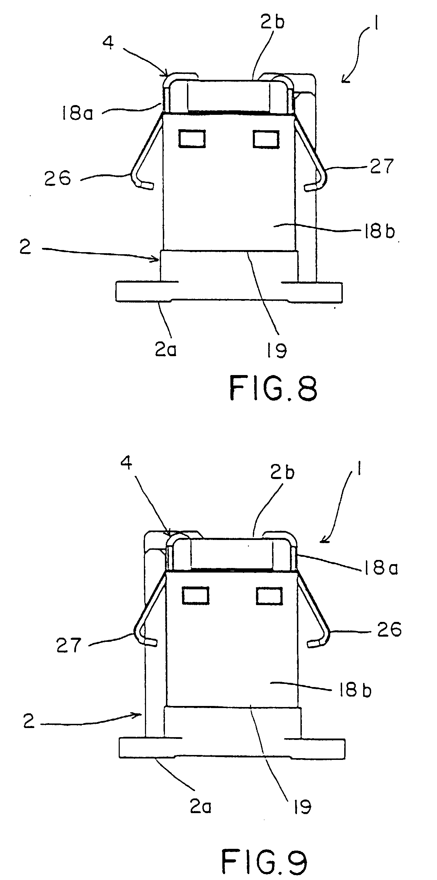

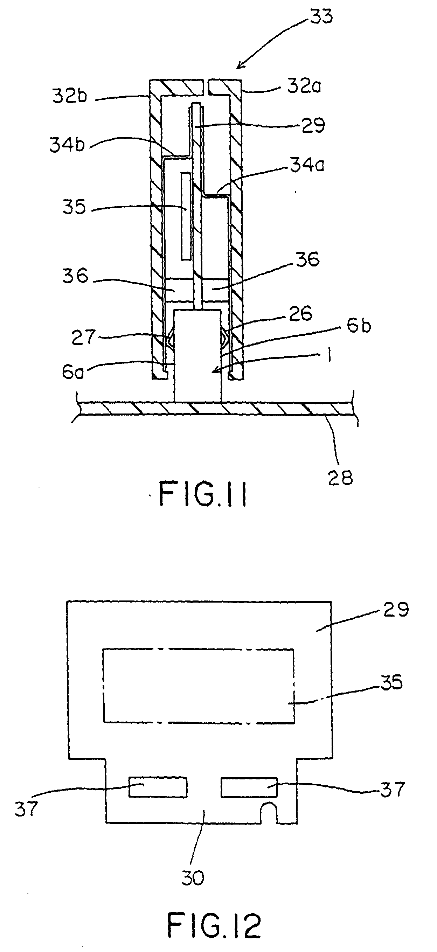

As stated above, metal shield 4 has fitting nails 23 and 24 integrally formed at its lower edge. These fitting nails extend downwardly to be flush with bottom surface 2a of the housing when the metal shield is mounted on the housing. In addition, major section 18a of the metal housing has two T-shaped pieces 25 (Fig. 5) at its opposite end areas. Each T-shaped piece 25 is bent inwardly at its free end and is bowed outwardly to define a spring finger 26. Similarly, semi-major sections 18c and 18d of the shield have spring fingers 27 at the opposite side of the connector and are positioned symmetrical with spring fingers 26 with respect to housing 2. These spring fingers 26 and 27 are bowed outwardly from the exterior of shield 4 as best seen in Figures 8 and 9 for engaging a complementary connecting device positioned over mating portion 2m of the connector, as described hereinafter in relation to Figure 11. The spring fingers may be used as grounding means for the complementary connecting device and/or to provide a resilient retaining means therefor.

It should be understood that the combined widths of cantilevered spring arms 22 (i.e. their spring forces) should be greater than the spring forces applied by spring fingers 26 and 27 on the outside of the shield against the complementary connecting device which is associated with the edge card or printed circuit board, so that spring fingers 26 and 27 do not interfere with or prevent cantilevered spring arms 22 from performing their function of biasing the edge card against datum plane 9 and contact stems 14a and 14b of terminals 3.

The electrical connector 1 described above is surface mounted on a mother board 28 as described hereinafter with reference to Figure 11. Soldering tails 13 of terminals 3 are soldered to selected circuit traces or pads on the mother board and, at the same time, fitting nails 22 and 24 of the metal shield are soldered to appropriate grounding pads (not shown) on the mother board, thus fixing edge connector 1 to the mother board.

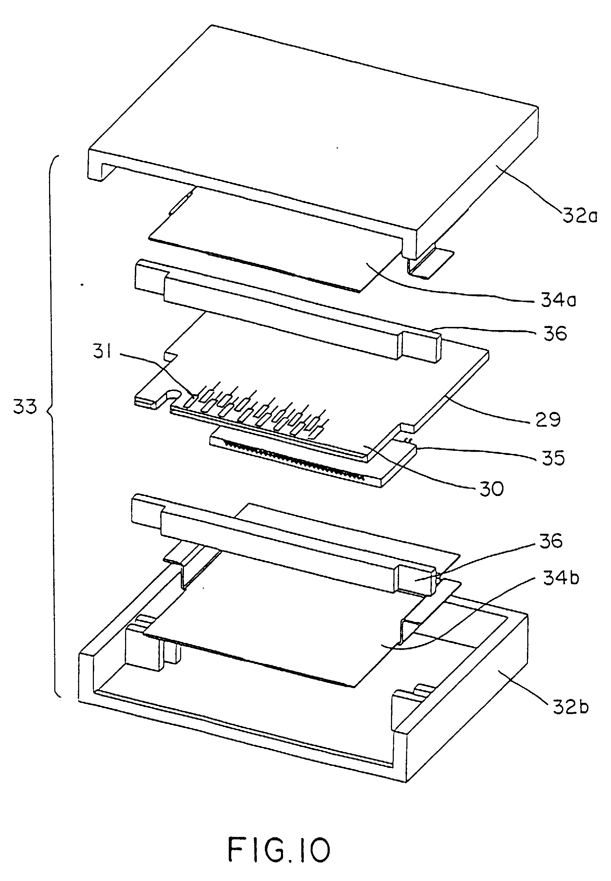

Referring to Figure 10, a printed circuit board 29 is shown to have a mating edge 30 for insertion into longitudinal slot 5 of edge connector 1. The printed circuit board has contact pads 31 spaced along the mating edge on one of the two opposite major surfaces of the board. The contact pads are arranged in two lines for registering with the longer and shorter contact stems 14a and 14b, respectively, of terminals 3. A cassette 33 includes two halves 32a and 32b secured together to form a box-like casing having an opening on one side. Printed circuit board 29 is contained in the casing with its mating edge 30 disposed at the opening in the casing, thereby permitting interconnection of the edge of the board with edge connector 1. Cassette 33 has a pair of metal shielding plates 34a and 34b to cover opposite sides of printed circuit board 29 when it is mounted within casing 33. In the drawing, a ROM 35 is attached to the printed circuit board, and a pair of support pieces 36 are used to hold the printed circuit board in casing 33.

Referring to Figure 11, printed circuit board 29 of cassette 33 is connected to mother board 28 through edge connector 1. When connector housing 2 is inserted into the lower opening of cassette 33, mating edge 30 of printed circuit board 29 is guided into slot 5 of the connector housing. While the mating edge of the printed circuit board 29 is guided into vertical space 10 of housing 2, the mating edge is biased toward datum plane 9 of the connector housing by resilient spring arms 22 of shield 4. At the same time, the resilient contact stems 14a and 14b of terminals 3 are biased from their stress-free positions to biased positions in which the contact stems are aligned generally flush with datum plane 9. Therefore, resilient spring arms 22 of shield 4 function as biasing means both for the mating edge of printed circuit board 29 and for the contact stems of terminals 3.

As seen best in Figures 2 and 3, resilient spring arms 22 of shield 4 are bowed or bent at their free ends similar to the contact stems of terminals 3 to define contact portions of the spring arms. These contact portions engage grounding contact pads 37 formed on the side of printed circuit board 29 opposite the side which has contact pads 31 (as seen in Figure 12). Therefore, metal shield 4 is electrically connected to a grounding circuit on printed circuit board 29.

Referring back to Figure 11, when the encased printed circuit board 29 is inserted into edge connector 1, shielding plates 34a and 34b of cassette 33 contact spring fingers 26 and 27, respectively, of metal shield 4. Therefore, printed circuit board 29 and terminals 3 of edge connector 1 are completely surrounded by shield plates 34a and 34b and metal shield 4, respectively, and the grounding circuit of mother board 28 is electrically connected to the grounding circuit of printed circuit board 29 through shield plates 34a and 34b and metal shield 4. Consequently, all associated grounding parts are kept at the same ground potential, providing complete shielding of the printed circuit from surrounding electromagnetic waves, or preventing electromagnetic waves from radiating from the printed circuit.

Metal shield 4 can be modified by eliminating spring fingers 26 and 27 and, accordingly, shield plates 34a and 34b can be modified by adding extra resilient extensions to contact the major section 18a, semi-major sections 18c and 18d of the metal shield 4. Also, the metal shield can be modified by removing fitting nails 23 and, accordingly, the housing can be modified by adding extra fitting nails thereto.

Because of the interconnection between cantilevered spring arms 22 and grounding pads 37 of printed circuit board 29, it is unnecessary for some selected terminals to be used for grounding part of the printed circuit. Therefore, all of the terminals can be allotted signal transmission functions. This is advantageous to connection of high-bit circuits. Relatively extensive contact is made between each grounding pad 37 of printed circuit board 29 and spring arms 22 of metal shield 4 and, therefore, an excellent shielding effect is assured. Remaining terminals, if any, may be connected to the grounding circuit of the printed circuit board. Lastly, in the embodiment described herein, metal shield 4 is a separate part assembled to housing 2 of edge connector 1. However, the metal shield could be insert-molded in the walls of the housing, although the independent assembly of the shield probably is easier than the insert molding of the shield.

## Claims

1. An edge connector (1) for receiving a printed circuit board (29) having a mating edge (30) and a plurality of contact pads (31) adjacent the edge, comprising:
an elongated dielectric housing (2) having an elongated mating portion (2m) with a board-receiving slot (5) for receiving the mating edge (30) of the printed circuit board (29);
a plurality of spring contact elements (14a,14b) mounted in the housing (2) along one side only of the slot (5) and having spring contact portions (14a, 14b) extending into the slot for contacting respective ones of the contact pads (31) on the printed circuit board (29) characterized by
a shield (4) being mounted on the housing (2) substantially about said mating portion (2m) , the shield including a resilient portion (22) in the form of a cantilevered spring arm extending into said slot (5) for contacting the printed circuit board (29) on the other side of the slot (5) and biasing the board against the spring contact elements (14a,14b) along said one side of the slot,
wherein said slot (5) includes an entry mouth into which the mating edge (30) of the printed circuit board (29) is inserted, and the cantilevered spring arm (22) of said shield (4) is bent from the exterior of the mating portion (2m) through the mouth into the slot (5) and
said cantilevered spring arm (22) has a width lengthwise of the slot (5) substantially greater than the width of the slot.

2. The edge connector of claim 1 wherein a surface on the housing at said one side of the slot means (5) defines a datum plane (9) beyond which the spring contact portions (14a,14b) of the spring contact elements (3) extend into the slot means (5), and wherein the resilient portion (22) biases the printed circuit board (29) against that datum plane (9) and that spring contact portion, thereby deflecting the spring contact portions (14a,14b) of said spring contact elements (3) a predetermined amount.

3. The edge connector of claims 1 or 2 wherein said shield (4) is a stamped and formed sheet metal structure and said resilient portion thereof comprises an integral cantilevered spring arm (22) extending into said slot (5).

4. The edge connector of claim 1, including a plurality of said cantilevered spring arms (22) having combined widths lengthwise of the slot (5) comprising a major portion of the overall length of the slot.

5. The edge connector of any of claims 1 to 4 wherein said shield (4) includes at least one spring finger (26,27) projecting from the exterior thereof for engaging a complementary connecting device (33) positioned over said mating portion, and said resilient portion (22) of the shield (4) is sufficiently larger than the spring finger (26,27) such that the spring finger does not prevent the resilient portion (22) from properly biasing the board (29) against the datum plane (9) and the spring contact portions (14a,14b).

6. In an edge connector as set forth in claim 5, including a plurality of said spring fingers (26,27) on the outside of the shield (4) with at least one spring finger (26,27) on each opposite longitudinal side of the elongated mating portion (2m).

## Patentansprüche

1. Randverbinder (1) zum Aufnehmen einer Leiterplatte (29) mit einem Rand (30) und einer Vielzahl von Kontaktflächen (31) benachbart zum Rand, welcher umfaßt
ein längliches dielektrisches Gehäuse (2) mit einem länglichen Zusammenfügeabschnitt (2m) mit einem plattenaufnehmenden Schlitz (5) zum Aufnehmen des Randes (30) der Leiterplatte (29),
eine Vielzahl von Federkontaktelementen (14a, 14b), welche im Gehäuse (2) entlang nur einer Seite des Schlitzes (5) befestigt sind und Federkontaktabschnitte (14a, 14b) aufweisen, welche sich in den Schlitz zum Berühren jeweiliger Kontaktflächen (31) an der Leiterplatte (29) erstrecken,
gekennzeichnet durch
eine Abschirmung (4), welche am Gehäuse (2) im wesentlichen um den Zusammenfügeabschnitt (2m) befestigt ist, wobei die Abschirmung einen elastischen Abschnitt (22) in Form eines freitragenden Federarmes umfaßt, welcher sich in den Schlitz (5) zum Berühren der Leiterplatte (29) an der anderen Seite des Schlitzes (5) erstreckt und die Platte gegen die Federkontaktelemente (14a, 14b) entlang einer Seite des Schlitzes vorspannt,
wobei der Schlitz (5) eine Einführöffnung umfaßt, in welche der Rand (30) der Leiterplatte (29) eingeführt wird und der freitragende Federarm (22) der Abschirmung (4) von außerhalb des Zusammenfügeabschnitts (2m) durch die Öffnung in den Schlitz (5) gebogen ist, und
wobei der freitragende Federarm (22) eine Breite längs des Schlitzes (5) aufweist, welche im wesentlichen größer als die Schlitzbreite ist.

2. Randverbinder nach Anspruch 1,
bei welchem eine Gehäusefläche an einer Seite des Schlitzes (5) eine Ebene (9) definiert, jenseits welcher sich die Federkontaktabschnitte (14a, 14b) des Federkontaktelements (3) in den Schlitz (5) erstrecken und bei welcher der elastische Abschnitt (22) die Leiterplatte (29) gegen die Ebene (9) und den Federkontaktabschnitt vorspannt, wodurch die Federkontaktabschnitte (14a, 14b) der Federkontaktelemente (3) um einen vorbestimmten Betrag gebogen sind.

3. Randverbinder nach den Ansprüchen 1 oder 2,
bei welchem die Abschirmung (4) eine gestanzte und geformte Metallblechstruktur aufweist und deren elastischer Abschnitt einen einteiligen freitragenden Federarm (22) umfaßt, der sich in den Schlitz (5) erstreckt.

4. Randverbinder nach Anspruch 1,
welcher eine Vielzahl freitragender Federarme (22) mit kombinierten Breiten längs des Schlitzes (5) umfaßt, welche einen Hauptabschnitt der Gesamtlänge des Schlitzes umfassen.

5. Randverbinder nach einem der Ansprüche 1 bis 4,
bei welchem die Abschirmung (4) wenigstens einen Federfinger (26, 27) umfaßt, der von außen hervorragt, um in eine komplementäre Verbindungseinrichtung (33) einzugreifen, die über dem Zusammenfügeabschnitt angeordnet ist, und der elastische Abschnitt (22) der Abschirmung (4) ausreichend größer als der Federfinger (26, 27) ist, so daß der Federfinger den elastischen Abschnitt (22) nicht daran hindert, die Platte (29) gegen die Ebene (9) und die Federkontaktabschnitte (14a, 14b) geeignet vorzuspannen.

6. Randverbinder nach Anspruch 5,
welcher eine Vielzahl von Federfingern (26, 27) an der Außenseite der Abschirmung (4) mit wenigstens einem Federfinger (26, 27) an jeder entgegengesetzten Längsseite des länglichen Zusammenfügeabschnitts (2m) umfaßt.

## Revendications

1. Connecteur (1) de bord destiné à recevoir une carte à circuit imprimé (29) comportant un bord (30) d'accouplement et une pluralité de plots (31) de contact adjacents au bord, comprenant :
un boîtier diélectrique allongé (2), comportant une partie (2m) d'accouplement allongée à fente (5) de réception de carte, destiné à recevoir le bord (30) d'accouplement de la carte à circuit imprimé (29) ;
une pluralité d'éléments (14a, 14b) de contact à ressort montés dans le boîtier (2) le long d'un côté seulement de la fente (5) et comportant des parties (14a, 14b) de contact à ressort s'étendant dans la fente pour contacter ceux, respectifs, des plots (31) de contact qui se trouvent sur la carte à circuit imprimé (29),
caractérisé par
un blindage (4) étant monté sur le boîtier (2) sensiblement autour de ladite partie (2m) d'accouplement, le blindage incluant une partie élastique (22) sous la forme d'un bras de ressort en porte-à-faux s'étendant dans ladite fente (5) pour contacter la carte à circuit imprimé (29) de l'autre côté de la fente (5), et pour rappeler la carte contre les éléments (14a, 14b) de contact à ressort le long dudit un côté de la fente,
dans lequel ladite fente (5) comprend une embouchure d'entrée dans laquelle on introduit le bord (30) d'accouplement de la carte à circuit imprimé (29), et dans lequel le bras (22) de ressort en porte-à-faux dudit blindage (4) est coudé à partir de l'extérieur de la partie (2m) d'accouplement à travers l'embouchure en pénétrant la fente (5), et
ledit bras (22) de ressort en porte-à-faux a une étendue, selon la longueur de la fente (5), sensiblement supérieure à la largeur de la fente.

2. Connecteur de bord selon la revendication 1, dans lequel une surface du boîtier, située dudit un côté du moyen (5) formant fente, définit un plan de référence (9) au-delà duquel les parties (14a, 14b) de contact à ressort des éléments (3) de contact à ressort s'étendent dans le moyen (5) formant fente, et dans lequel la partie élastique (22) rappelle la carte à circuit imprimé (29) contre ce plan de référence (9) et cette partie de contact à ressort, en déviant ainsi, d'une quantité prédéterminée, les parties (14a, 14b) de contact à ressort desdits éléments (3) de contact à ressort.

3. Connecteur de bord selon les revendications 1 ou 2, dans lequel ledit blindage (4) a une structure de métal en feuille découpée et formée à la presse, et dans lequel ladite partie élastique de celui-ci comprend un bras (22) de ressort en porte-à-faux intégré s'étendant dans ladite fente (5).

4. Connecteur de bord selon la revendication 1, comprenant une pluralité desdits bras (22) de ressort en porte-à-faux ayant des étendues combinées dans le sens de la longueur de la fente (5) comprenant une majeure partie de la longueur totale de la fente.

5. Connecteur de bord selon l'une quelconque des revendications 1 à 4, dans lequel ledit blindage (4) comprend au moins un doigt (26, 27) de ressort, en saillie de sa partie extérieure, destiné à coopérer avec un dispositif (33) de connexion complémentaire placé sur ladite partie d'accouplement, et dans lequel ladite partie élastique (22) du blindage (4) est suffisamment plus grande que le doigt (26, 27) de ressort pour que le doigt de ressort n'empêche pas la partie élastique (22) de rappeler correctement la carte (29) contre le plan de référence (9) et les parties (14a, 14b) de contact à ressort.

6. Connecteur de bord selon la revendication 5, comprenant une pluralité desdits doigts (26, 27) de ressort à l'extérieur du blindage (4), au moins un doigt (26, 27) de ressort étant situé sur chaque côté longitudinal opposé de la partie (2m) d'accouplement allongée.
